(19) Europäisches Patentamt / European Patent Office / Office européen des brevets

(11) **EP 3 769 386 B1**

(12) **EUROPEAN PATENT SPECIFICATION**

(45) Date of publication and mention
of the grant of the patent:
**02.02.2022 Bulletin 2022/05**

(21) Application number: **18712601.6**

(22) Date of filing: **21.03.2018**

(51) International Patent Classification (IPC):
*H02H 3/04* *(2006.01)*   *H02H 3/18* *(2006.01)*
*H02H 7/20* *(2006.01)*   *G01R 31/26* *(2020.01)*
*G01R 31/327* *(2006.01)*

(52) Cooperative Patent Classification (CPC):
**G01R 31/2633; G01R 31/3271; H02H 3/044;**
**H02H 3/18;** H02H 7/205

(86) International application number:
**PCT/EP2018/057139**

(87) International publication number:
**WO 2019/179613 (26.09.2019 Gazette 2019/39)**

(54) **HEALTH INVESTIGATION IN A CIRCUIT BREAKER**

ÜBERWACHUNG DES GESUNDHEITSZUSTANDES BEI EINEM SCHUTZSCHALTER

ENQUÊTE SUR LA SANTÉ DANS UN DISJONCTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**27.01.2021 Bulletin 2021/04**

(73) Proprietor: **Hitachi Energy Switzerland AG
5400 Baden (CH)**

(72) Inventors:
• **KUMAR, Aneesh
77140 Ludvika (SE)**
• **PAMULAPATI, Siva Nagi Reddy
77143 Ludvika (SE)**

• **VINNBERG, Andreas
77132 Ludvika (SE)**
• **KARLSSON, Patrik
77142 Ludvika (SE)**
• **PETERSSON, Yngve
77143 Ludvika (SE)**

(74) Representative: **AWA Sweden AB
P.O. Box 45086
104 30 Stockholm (SE)**

(56) References cited:
**WO-A1-2017/157440   CN-A- 107 422 257
US-A- 3 745 548   US-A1- 2004 125 518**

**Description**

TECHNICAL FIELD

The invention is generally related to investigating the health of unidirectional conducting elements in circuit breakers. More particularly, the invention relates to a health investigating arrangement for a first unidirectional conducting element acting as a main circuit breaker element of a circuit breaker, a circuit breaker comprising such a health investigating arrangement and a transmission system comprising such a circuit breaker.

BACKGROUND

In power transmission systems, such as High Voltage Direct Current (HVDC) power transmission there is often a need for a circuit breaker in order to disconnect a power line or cable during pole faults, such as pole-to-ground faults or reverse polarities. This may be done in order to protect a main converter valve from reverse polarities caused by the system. A DC circuit breaker may then comprise a main breaker made up of a number of series-connected semiconducting components in parallel with a surge arrester. There may also be an electronic load commutation switch and mechanical disconnector connected in parallel with the main breaker.

The main breaker is often, especially when bidirectional current conduct is contemplated, realized through a combination of force commutated semiconductor switches, such as transistors with anti-parallel diodes.

It is in some cases of interest to replace the above-mentioned force commutated switches with self-commutated semiconductors or unidirectional conducting elements, such as diodes. This may be advantageous when only one current conduction direction is actually contemplated in the power transmission system, in which case no logic is needed for controlling the main breaker to interrupt current.

However, it is at the same time of interest to monitor the health of such a self-commutated semiconductor or unidirectional conducting element, i.e. in order to determine if it is functioning properly or not.

Some schemes of monitoring diodes are known.

US 2004/0125518 discloses the monitoring of a diode that acts as a reverse current protection device for a fuel cell. The voltage across the diode is measured and inverted. The inverted voltage is then compared with a threshold in order to determine that the diode is good if the threshold is exceeded.

CH 513539 discloses a semiconductor valve monitoring device for high voltage applications, where a valve may be made up of diodes or thyristors as valve elements. The health of thyristors of the valve is determined through comparing, in an amplifier, the voltage across the whole valve with the voltage across a first of the valve elements.

A diode used in a high voltage system will essentially have two healthy states; a forward biased state and a reverse biased state. The forward biased state typically involves a fairly low voltage across the diode, such as in the range 0.8 - 1.35 V, while a reverse biased voltage will be considerably higher, such as in the range 3 - 5 kV. In addition to this a faulty diode may have a voltage around zero.

Due to the discrepancy between the voltage levels of the different states and particularly between the healthy states, it is also hard to differentiate between the different states and especially between a faulty and a healthy forward biased state. Consequently, it may be hard to determine the health.

The invention addresses this problem of simplifying differentiating between the different states of a unidirectional conducting element in order to improve on the determining of the health of the semiconductor.

WO 2017/157440 A1 discloses a current limiting device for a high voltage equipment in a high voltage direct current power system, where the equipment comprises a disconnector operable to obtain a mechanical separation from a power line conductor of the system. The current limiting device comprises a first current limiting circuit for connection between the power line conductor and a first connection terminal of the equipment and the first current limiting circuit is operable to reduce alternating currents in the frequency range of 70-200 kHz.

US 3,745,548 A discloses an apparatus for monitoring a rectifier leg which forms a part of a system that is being supplied with electrical power from an external circuit. The rectifier leg has at least first and second series connected rectifier cells. The monitor apparatus includes a source of control power for supplying electrical power to the monitor apparatus as well as to the rectifier leg. The monitor apparatus provides an indication of open and short circuit failure of the rectifier cells while they are in use in the system and being supplied with electrical power from the external circuit or while they are being supplied with electrical power solely by the source of control power of the monitor apparatus.

CN107422257A discloses, according to a machine translation thereof, a relay detection circuit and a relay detection unit, and relates to the battery field. The relay detection circuit comprises a pull-up power supply, a first channel module, a second channel module, a first contact, and a second contact. The first contact is connected with a first end of a negative electrode relay, which is serially connected with a to-be-tested power battery pack, during the detection of the negative electrode relay. The second contact is connected with the second end of the negative electrode relay during the detection of the negative electrode relay. When the negative electrode relay is in a working state, the pull-up power supply and the first channel module are used to form a circuit, or the pull-up power supply, the first channel module, and the second channel module are used to form the circuit.

SUMMARY

One object of the invention is thus to improve the determining of the health of a unidirectional conducting element.

This object, according to a first aspect and defined by claim 1, is achieved by a health investigating arrangement for a first self-commutated unidirectional conducting element acting as a main circuit breaker element of a circuit breaker connected in series with a direct current power transmission medium, the element having a reverse blocking state with a first voltage level, a forward conduction state with a second voltage level and a faulty state with a third voltage level, wherein the absolute value of the second voltage level is higher than the absolute value of the third voltage level and the absolute value of the first voltage level is more than ten times higher than the absolute value of the second voltage level. The health investigating arrangement comprises a voltage dividing circuit connected in parallel with the first unidirectional conducting element, the voltage dividing circuit comprising:

a first voltage handling block connected in series with a second voltage handling block, the first voltage handling block comprising a first voltage dividing component and the second voltage handling block comprising a second voltage dividing component, the first and second voltage dividing components having a relationship between each other set to divide the voltage of the reverse blocking state down to a level that can be handled by a signal evaluating circuit, where a junction between the first and second voltage handling blocks forms a health signal output on which a health signal capable of representing all states of the first unidirectional conducting element is provided, wherein the second voltage handling block comprises a second unidirectional conducting element with opposite orientation compared with the first unidirectional conducting element in order to remove the voltage division of the first and second voltage dividing components from the health signal when the first unidirectional conducting element is in the forward conduction state.

This object, according to a second aspect and defined by claim 14, is also achieved by a circuit breaker comprising a unidirectional conducting element acting as a main circuit breaker element and a health investigating arrangement according the first aspect.

The object, according to a third aspect and defined by claim 15, is achieved by a power transmissions system comprising a transmission medium and a series-connected circuit breaker according to the second aspect.

The unidirectional conducting element may be a unidirectional conducting semiconductor such as a diode or a thyristor. It may also be seen as a self-commutating element or self-commutating semiconductor as it is turned off by itself and not through the reception of a control signal. It may also be considered to be a reverse-bias turn off element as it may be turned off through being reverse biased. In case of a diode it may also be seen as a forward-bias turn on element as it may be turned on through being forward biased. The first voltage level may have a polarity that is the opposite of the polarity of the second voltage level. The absolute value of the first voltage level may additionally be more than one thousand times higher than the absolute value of the second voltage level and with advantage more than two thousand times higher than the absolute value of the second voltage level.

The invention according to the above-mentioned aspects has a number of advantages. It allows the different states of the unidirectional conducting element to be safely detected in a simple, effective and reliable way even though the monitored voltage may be both at extremely low levels and at high levels.

The first and second voltage handling blocks may be realized only using passive components and thereby the health signal can be obtained without the use of any power supply, which may be hard to implement locally at the circuit breaker.

It should be emphasized that the term "comprises/comprising" when used in this specification is taken to specify the presence of stated features, integers, steps or components, but does not preclude the presence or addition of one or more other features, integers, steps, components or groups thereof.

BRIEF DESCRIPTION OF THE DRAWINGS

The present invention will in the following be described with reference being made to the accompanying drawings, where

fig. 1 schematically shows a simple HVDC system comprising a power transmission medium in the form of a power line or cable connected to a circuit breaker,

fig. 2 schematically shows the circuit breaker comprising a main breaker made up of a number of series-connected diodes and a health investigating arrangement connected in parallel with one of the diodes,

fig. 3 schematically shows the health investigating arrangement and one of the diodes, where the arrangement comprises a power supply circuit, a voltage dividing circuit and a signal evaluation circuit,

fig. 4 schematically shows the diode together with the voltage dividing circuit and a first variation of the power supply circuit,

fig. 5 schematically shows one realization of the voltage dividing circuit,

fig. 6 schematically shows one realization of the signal evaluating circuit,

fig. 7 shows an exemplifying realization of the first variation of the power supply circuit,

fig. 8 schematically shows one way in which a health evaluation signal may be encoded for indicating various states of the diode according to another realization of the voltage dividing circuit, and

fig. 9 schematically shows the voltage dividing circuit together with a second variation of the power supply circuit.

DETAILED DESCRIPTION

In the following, a detailed description of preferred embodiments of the invention will be given.

The invention is concerned with a health investigating arrangement for a unidirectional conducting element as well as to a circuit breaker connected in series with a direct current power transmission medium. It is also directed towards a direct current power transmission system comprising such a transmission medium and circuit breaker.

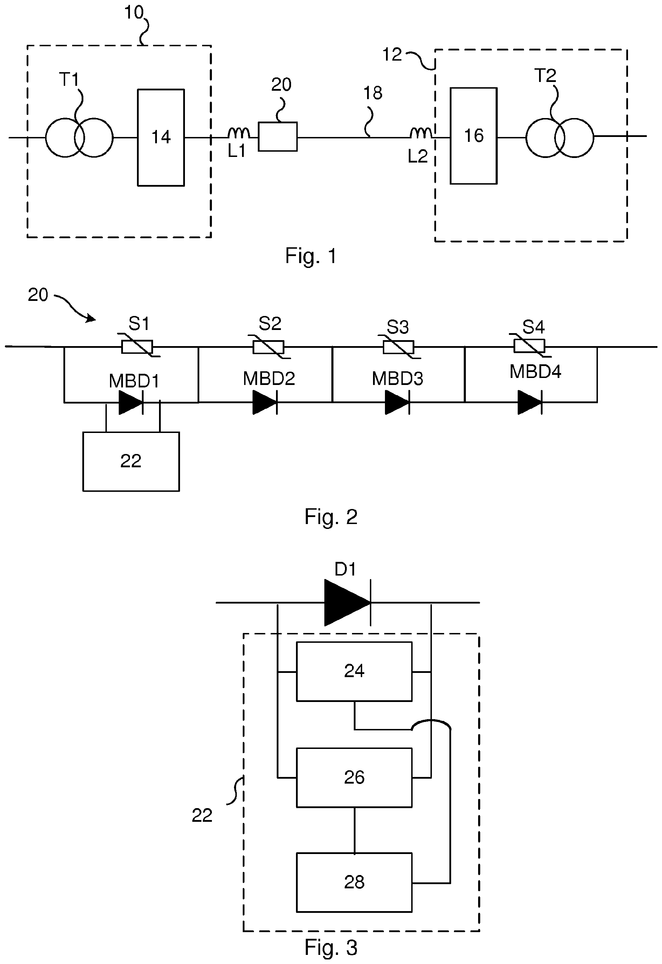

Fig. 1 shows one variation of a high voltage direct current (HVDC) power transmission system.

The system in fig. 1 is a point-to-point system for connection between two Alternating Current (AC) power transmission systems. For this reason, the HVDC system includes a first and a second converter station 10 and 12, where the first converter station 10 includes a first transformer T1. The first converter station 10 also comprises a first converter 14 for conversion between AC and DC, which converter 14 therefore comprises an AC side connected to the transformer T1 and a DC side connected to a first reactor Li. The first transformer T1 thus connects the first converter 14 to the first AC power transmission system (not shown). The first converter 14 is connected to a second converter 16 of a second converter station 12 via a DC transmission medium 18, which DC transmission medium may be a power line or cable. As described earlier, the first converter 10 may here be connected to a first end of the transmission medium via a first reactor Li and the second converter may be connected to a second end of the transmission medium 18 via a second reactor L2. The second converter 16 also converts between AC and DC and may be an inverter. The second converter station 12 may also include a second transformer T2, which connects the second converter 16 to the second AC power transmission system (not shown).

The converters 14 and 16 may be any type of converters, such as linecommutated Current Source Converters (CSC) or forced commutated Voltage Source Converters (VSC). The converters may more particularly comprise a number of converter valves. A voltage source converter may be a two-level voltage source converter or a multi-level voltage source converter employing cells. In series with the transmission medium there is finally also a circuit breaker 20. Although only one is shown, it should be realized that there may be one such circuit breaker in the proximity of a converter, for instance in proximity of each converter. There may thus be a device on opposite sides of the transmission medium 18.

The HVDC system in fig. 1 is a monopole system. It should however be realized that the system may also be a bipole system.

As another alternative it is possible that the HVDC system is a multiterminal HVDC system, such as an HVDC system comprising a number of converters connected to a DC grid, where the converters convert between AC and DC. In this case the power lines of such a grid may each comprise one, two or more circuit breakers.

Fig. 2 shows one way in which the circuit breaker 20 may be realized. The circuit breaker 20 may be made up of one or more series connected blocks, where four blocks are shown in fig. 2. In such a block there may be a set of parallel branches. In this example the set is made up of two parallel branches. There is a first main breaker branch and a second surge arrester branch. Here each surge arrester branch comprises a surge arrester and each main breaker branch comprises a self-commutated unidirectional current conducting element or self-commutated semiconducting element in the form of a diode. Thereby there is a first, second, third and fourth diode MBD1, MBD2, MBD3 and MBD4 connected in series for forming a main breaker.

It should be realized that the shown circuit breaker 20 is merely one possible realization. There exist a multitude of different realizations, such as through each module comprising a mechanical disconnector and/or each module comprising a snubber circuit in parallel with the main breaker branch and surge arrester branch. It is also possible that the circuit breaker is not modular, but that instead three parallel strings with diodes, surge arresters and load commutation switch with mechanical disconnector are provided. Another possible realization is to connect a load commutation branch comprising an electronic load commutation switch and a mechanical disconnector in parallel with the main breaker branch and surge arrester branch.

However, the main breaker is in all these variations realized using self-commutated semiconductor or unidirectional current conducting elements or semiconductors, which in this case are also diodes. For this reason, the circuit breaker 20 may also be considered to be a diode valve.

In the figure there is also shown a health investigating arrangement 22 connected in parallel with a first of the diodes MBD1. The health investigating arrangement 22 is provided for investigating the health of the diode: It should be realized that all the diodes MBD1, MBD2, MBD3 and MBD4 of the main breaker 20 may be connected to such a health investigating arrangement 22, even though only one is shown.

Fig. 3 schematically shows one way of realizing the health investigating arrangement 22. As can be seen the health investigating arrangement 22 comprises a power supply circuit 24 connected in parallel with the diode MBDi as well as a voltage dividing circuit 26 connected in parallel with the power supply circuit 24. There is also a signal evaluation circuit 28 connected to both the power supply circuit 24 and voltage dividing circuit 26. The power supply circuit 24 supplies power for operating circuits of the arrangement, like the signal evaluating circuit 28 and perhaps also the voltage dividing circuit 26, which power is obtained through the voltage across the diode MBD1. The voltage dividing circuit 26 provides a monitored voltage Vmon to the signal evaluating circuit 28 for evaluation of the health of the diode MBD1. The signal evaluating circuit 28 thus determines the state of the first unidirectional conducting element MDB1 based on the health indication signal Vmon.

It should here be realized that it is possible that the signal evaluating circuit 28 is provided with an own local power supply, in which case the power supply circuit 24 may be omitted. The signal evaluating circuit 28 may also be provided with power from voltage divider circuit 26 itself under specific conditions and in this case power supply 24 may also be omitted.

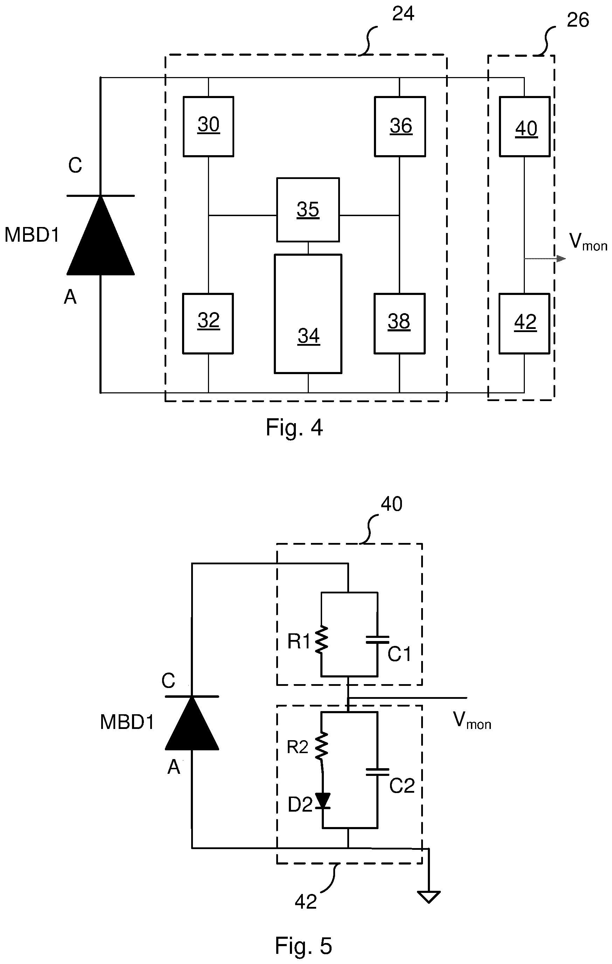

Fig. 4 shows the voltage dividing circuit 26 together with a first realization of the power supply circuit 24. The power supply circuit 24 comprises a first DC/DC converter 34 and a first and a second voltage dividing block 30 and 32, where the first voltage dividing block 30 is connected in a first string in series with the second voltage dividing block 32. where the first string with these two blocks is furthermore connected in parallel with the diode MBD1. Moreover, the first voltage dividing block 30 is connected to the cathode C of the diode MBDi and the second voltage dividing block 32 is connected to the anode A of the diode MBD1. There is also a third voltage dividing block 36 connected in series with a fourth voltage dividing block 38, where also these two blocks are connected in parallel with the diode MBD1, where the third voltage dividing block 36 is connected to the cathode C of the diode MBDi and the fourth voltage dividing block 38 is connected to the anode A of the diode MBD1. A first junction between the first and second voltage dividing blocks 30 and 32 is connected to a first input of the first DC/DC converter 34. Also, a second junction between the third and fourth voltage dividing blocks 36 and 38 is connected to the first input of the first DC/DC converter 34. In this first variation of the power supply circuit 24, the first junction as well as the second junction is connected to the first input terminal of a first DC/DC converter 34 via a selecting block 35. There is thus a selecting block 35 connected between the first junction, the second junction and the first input of the first DC/DC converter 34. Also a junction between the anode A of the diode MBD1, the second voltage dividing block 32 and the fourth voltage dividing block 38 is connected to a second input terminal of the first DC/DC converter 34. The first and second voltage dividing blocks 30 and 32 may be considered to form a first voltage divider and the third and fourth voltage dividing blocks 36 and 38 may be considered to form a second voltage divider. It should here be realized that the functionality of the selecting block 35 is optional and that the functionality of it may be included in the first and/or second voltage divider.

The voltage dividing circuit 26 is connected in parallel with the first unidirectional conducting element (MBD1). The voltage dividing circuit 26 comprises a first voltage handling block 40 connected in series with a second voltage handling block 42 and this series connection is likewise connected in parallel with the diode MBD1, where the first voltage handling block 40 is connected to the cathode C of the diode MBDi and the second voltage handling block 42 is connected to the anode A of the diode MBD1. There is furthermore a junction between these two blocks 40 and 42 and this junction forms a health signal output that is connected to the signal handling circuit 28. On the health signal output there is provided a monitoring voltage Vmon that is a health signal indicative of the state of the diode MBD1.

Fig. 5 shows an exemplifying realization of the first and second voltage handling blocks 40 and 42 of the voltage dividing circuit 26 in parallel with the main breaker diode MBD1, which diode is here also considered to be a first diode. As can be seen the first voltage handling block 40 comprises a first voltage dividing component, here in the form of a first resistor R1 in parallel with a first reactive component, here in the form of a first capacitor C1, while the second voltage handling block 42 comprises a series circuit comprising a second voltage dividing component, here in the form of a second resistor R2, connected in series with a second unidirectional conducting element, here exemplified by a second diode D2. In parallel with this series circuit there is connected a second reactive component, here in the form of a second capacitor C2. It may also be seen that the second diode D2 has the opposite orientation compared with the first diode MBD1. It more particularly has the cathode connected to the anode A of the first diode MBDi and the anode connected to the second resistor R2. As the reactive components of the two blocks are both capacitor, it can be seen that they are of the same type.

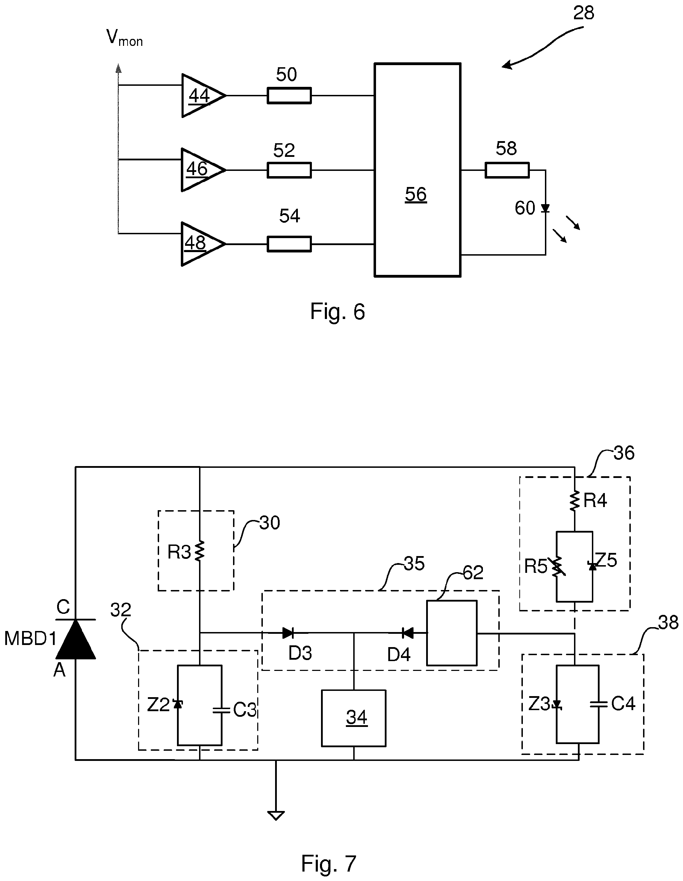

Fig. 6 schematically shows one exemplifying realization of the signal evaluating circuit 28. It comprises three inputs, each receiving the monitored signal Vmon, where a first input is connected to a first comparator 44 that in turn is connected to monitoring logic 56 via a first resistor 50, a second input is connected to a second comparator 46 that in turn is connected to the monitoring logic 56 via a second resistor 52 and a third input is connected to a third comparator 48 that in turn is connected to the monitoring logic 56 via a third resistor 54. The monitoring logic 56 has an output connected to a light emitter 60, here exemplified by a light emitting diode (LED), via a fourth resistor 58. The comparators are provided for comparing the voltage Vmon with a corresponding voltage threshold in order to indicate a state of the diode MBDi and the monitoring logic 56 may code the state of the diode for provision to a main control unit.

There are several ways in which the monitoring logic may be provided. It may be provided as a processor with associated memory comprising software code implementing its functionality. It may also be implemented as a dedicated circuit such as an Application Specific Integrated Circuit (ASIC) or a Field-Programmable Gate Array (FPGA).

It may here also be mentioned that the health investigating arrangement 22 may be provided at a high potential, while the main control unit may be provided at a low potential such as at ground potential. Also, the LED may be replaced with a laser. It is furthermore possible to use electricity and an electric cable instead of a light emitter and optical fibre.

Fig. 7 shows an exemplifying realization of the power supply circuit 24, where the first voltage dividing block 30 is realized as a third resistor $R_3$, the second voltage dividing block as a Zener diode Z2 in parallel with a third capacitor C3 where the anode of the Zener diode Z2 is connected to the anode of the first diode MBD1, the third voltage dividing block 36 is realized as a fourth resistor R4 in series with a parallel circuit made up of a fifth variable resistor R5 and a Zener diode Z5, the anode of which is connected to the second junction, and the fourth voltage dividing block is realized as a Zener diode Z3 in parallel with a fourth capacitor C4, where the cathode of the Zener diode Z3 is connected to the anode of the first diode MBD1. The selecting block 35 may be realized as two strings connected between junctions associated with voltage dividing blocks and the first input of the first DC/DC converter 34. In the example in fig. 7, the selecting block 35 is realized as a first string with a diode D3 connected between the first junction and the first input of the first DC/DC converter 34 and as a second string with a second inverting DC/DC converter 62 and a diode D4 connected between the second junction and the first input of the first DC/DC converter 34. In this case the diode D4 of the second string is placed after the second converter 62, i.e. the second converter 62 is connected to the first input of the first DC/DC converter 34 via the diode D4. Both diodes D3 and D4 are furthermore connected to the first input of the first DC/DC converter 34 with their cathodes. The second DC/DC converter 62 may as an example be realized as an inverting Buck-boost converter, although other realizations are contemplated.

The functioning of the health investigating arrangement 22 will now be described in somewhat more detail.

A self-commutated semiconducting element or unidirectional conducting element, such as a diode, may be used as a main breaker element in a circuit breaker connected in series with a power transmission medium, such as a power line or an underground cable in case the transmission medium has a unidirectional power flow. This may for instance be the case if the converter station uses a current source converter.

When this is the case a fault, like a ground fault, or a voltage polarity reversal caused by the system during any type of fault, may cause the current through the power transmission medium to reverse its current direction, which in turn causes the diode to be reverse biased and thereby being turned off. This turning off can then be achieved without the use of control signals. This may simplify and speed up fault handling in the above described type of systems. A diode may also be advantageous for other reasons, such as because of costs.

The diode may also need to be monitored regarding its health. However, this it is not that simple.

A diode may have three states, where two of the states are associated with a healthy diode and the third of the states is associated with a faulty diode. A healthy diode may be conducting current, in which case it is forward biased or it may be blocking current, in which case it is reverse biased. It may also be faulty, in which case there is essentially a zero voltage across it. The reverse biased healthy diode is here a first reverse blocking state, the forward-biased healthy diode a second forward conduction state and a faulty diode a third faulty state.

However, when the diode is in first state, the voltage across it has a first level, the absolute value of which is typically in the range 3 - 5 kV. The first level typically also has a reversed polarity compared with the second state and often also the third state. When the diode is in the second state the voltage across it has a second level, the absolute voltage of which is much lower than the absolute value of the first voltage level. The second level is typically in the range of 0.8 - 1.35 V. When the diode is in the third state the voltage across it has a third level that is typically around or approximately zero V. It can thereby be seen that the absolute value of the second voltage level is higher than the absolute value of the third voltage level and the absolute value of the first voltage level is higher than the absolute value of the second voltage level. It may as an example be more than ten times higher. Sometimes it is more than one thousand times higher. In many cases, such as in the examples above, it is more than two thousand times higher.

Now, when monitoring the health, it is often preferable to use the voltage across the diode in order to differentiate between the different states. It is also of interest to use as few different measured voltages as possible in order to perform an evaluation of the health. However, this is not that easy to realize due to the very different voltage levels that appear for the different states. The challenge lies in the fact that the diode voltage may be extremely low (diode on condition) and very high (diode off condition).

It may be necessary to monitor the health of the diode in the circuit breaker in a simple and reliable way. It should thus be possible to identify and notify a main control unit about the diode mode of operation along with information regarding the health of the diode.

Aspects of the invention are provided for addressing this problem.

This problem is essentially addressed using the voltage dividing circuit 26, where the first and second voltage handling blocks 40 and 42 can be seen as making up a third voltage divider that divides the voltage across a first diode MBD1 to be monitored both when being forward and reverse biased for obtaining the monitored voltage Vmon. In this voltage dividing circuit the relationship between the first and second resistor R1 and R2 is typically selected so that the voltage Vmon lies close to the forward biased range of 0.8 - 1.35 V when the diode MBD1 is reverse biased. The first and second voltage dividing components R1 and R2 thus have a relationship between each other set to divide the voltage of the reverse blocking state down to a level that can be handled by the signal evaluating circuit 28. R1 may as an example be in the range of one thousand times larger than R2.

It can be seen in fig. 5, that for a reverse-biased first diode MBD1, the second diode D2 will be conducting and consequently there is a voltage division at the junction between the two voltage handling blocks 40 and 42 defined by R2/(R1 + R2), which would in case R1 is 1000*R2 lead to a division of the voltage across the diode by 1000 and thereby Vmon would be a few voltages large.

It can seen that for a forward biased first diode MBD1, the second diode D2 would be reverse-biased and therefore the second resistor R2 is floating and will not take part in any voltage division. The orientation of the second diode D2 compared with the orientation of the first diode MBDi thereby removes the voltage division of the first and second voltage dividing components from the health signal when the first unidirectional conducting element is forward biased, i.e. in the forward conduction state. In this case the first resistor R1 and the second capacitor C2 forms an RC filter that filters the diode voltage. It can in this case be seen that the monitored voltage Vmon would essentially be identical to the forward-biased diode voltage, i.e. around 0.8 - 1.35 V. The monitored voltage Vmon representing the forward biased voltage would therefore be in roughly the same range as the monitored voltage Vmon representing the reverse biased voltage but clearly lower than the voltage of the divided down first state and thereby they can be easily differentiated. Here it may also be mentioned that the voltages could have opposite polarities, with one being positive and the other negative.

It can thereby also be seen that the health signal Vmon is capable of representing all states of the first unidirectional conducting element.

Put differently and analysed in some more detail, the operation may be seen as being the following:

a) Reverse blocking state: When the diode MBDi is reverse biased, the reverse biased blocking voltage ($V_R$ - typically 3 to 5kV) shall be applied at the cathode terminal C of diode D1 with respect to anode A. When the reverse biased voltage is applied, the diode D2 in the voltage divider circuit is forward biased and the division ratio at the health signal output is,

$$V_{mon} = V_{D2ON} + \frac{R_2\left(V_{mon} - V_{D2ON}\right)}{(R_1 + R_2)}$$

where $V_{D2ON}$ is the voltage drop across the second diode D2 when it is forward-biased. It can be seen that the divider voltage has been offset by the diode forward voltage $V_{D2ON}$ of D2 and this offset voltage may be considered for the signal evaluating circuit.

b) Forward biased state: During the time that the diode MBDi is forward biased, the forward biased voltage (VD - typically 0,8V to 1.35V) appears across anode to cathode. The divider circuit shown in the figure 5 is referenced to the local ground at the anode terminal. Hence the voltage appearing at the cathode terminal C with respect to anode terminal A of the diode MBDi is the negative forward voltage drop of the diode and this voltage appears as a reverse bias voltage for diode D2. With the diode D2 reverse biased, the resistance R2 becomes open and hence the divider becomes an RC filter with R1 in series with C2. Hence the divided voltage at the health signal output is,

$$V_{mon} = -V_{DON}$$

where $V_{DON}$ is the forward bias voltage of the first diode MBD1

It can likewise be seen that a zero voltage would not be problematic to differentiate.

Thereby voltages that are in the same range are provided and these voltages may then be supplied to the signal evaluating circuit 28 for evaluation.

The signal evaluating circuit 28 receives the monitored voltage Vmon representing the voltage across the first diode MBD1, analyses the voltage Vmon in order to determine the state and sends an indication of the state of the diode to a main control unit, which may be provided in a converter station control unit and at ground potential. The indication may be sent using the light emitting element 60 and an optical fibre.

As an example, the monitored voltage may be compared in the first comparator 44 with a first threshold representing the first state, in the second comparator 46 with a second threshold representing the second state and in the third comparator 48 with a third threshold representing the third state. The comparator for which the threshold is crossed then sends a signal representing the corresponding state to the monitoring logic 56, which in turn sends a signal representing the state to the main control unit via the optical fibers. It can thus be seen that the signal evaluating circuit 28 determines the state of the first unidirectional conducting element MDBi through comparing the health indication signal Vmon with three different thresholds, each associated with a corresponding state, and indicates the state for which the corresponding threshold is crossed.

There are a number of ways in which the state may be obtained from the monitored voltage Vmon. This monitored voltage may also be termed a diode position voltage since it is used to indicate if the diode is in a forward or reverse biased position.

    a) As was described above it is possible to use three different comparators that receive diode position voltage Vmon through the voltage dividing circuit 26. The main control unit can determine the diode operating mode with a simple protocol from the monitoring logic circuit or the actual voltage measured can be sent as an encoded data to ground potential controllers.

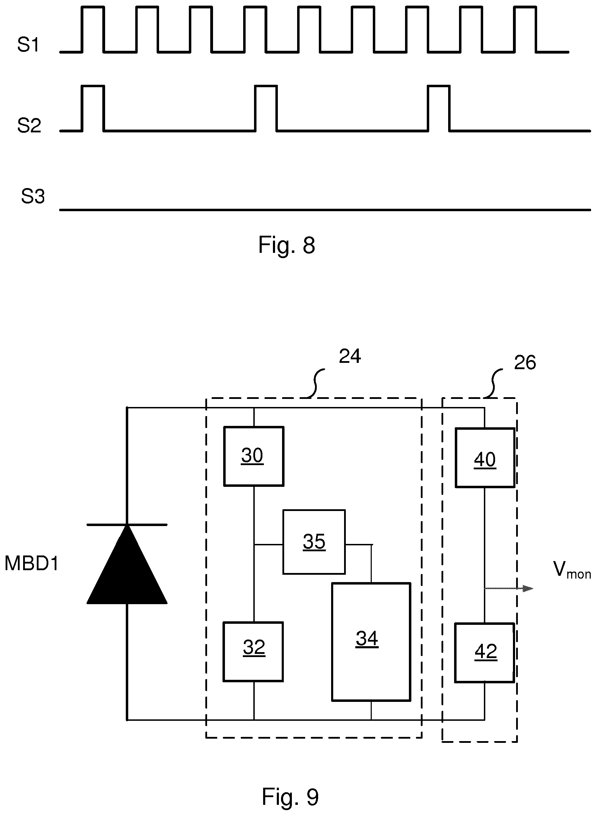

    b) As an alternative the energy in the monitoring capacitor C2 may be used to trigger a pulse train through the optical fiber. The width of the pulse shall be the same, but the rate/frequency at which the pulses come indicates the operating mode/voltage of the diode. In this case the signal evaluating circuit 28 codes the voltage level of the health indication signal Vmon into a pulse train having a pulse repetition rate corresponding to the voltage level of the health indication signal Vmon in order to indicate the state. The pulse repetition rate of the first state may then be higher than the pulse repetition rate of the second state, which in turn may be higher than the pulse repetition rate of the third state, which latter rate may be zero. An example of such a coding can be seen in fig. 8, which shows the first state Si, the second state S2 and the third state $S_3$. As can be seen the diode is considered as failed if there are no pulses.

    c) A third way is to sample the divided monitoring diode position voltage Vmon using an analog digital converter (ADC) and send to the ground potential through the optical fiber.

The signal evaluating circuit 28 needs external power in order to be able to perform its functions. Optionally also the voltage dividing circuit 26 may need such external power. This power may be provided through a regular power supply. However, in some cases there is no network available to which such a power supply may be connected and in this case it is possible to instead use the voltage across the diode MBD1. This is the purpose of the power supply circuit 24.

Moreover, as has been stated above, in operation the voltage across the diode can vary considerably. The power supply circuit 24 is provided for handling this and generate a stable power supply voltage.

As can be seen in fig. 4, the power supply circuit 24 comprises a first, second, third and fourth voltage dividing block 30, 32, 36 and 38. A voltage dividing block may be provided as a parallel circuit comprising a resistor in parallel with a capacitor. Optionally there may also be a diode, like a Zener diode, in parallel with a resistor and/or capacitor. It is also possible with a further resistor in series with a parallel circuit.

The first second, third and fourth voltage dividing blocks 30, 32, 36 and 38 are dividing the voltage across the diode MBDi in order to generate power for energizing the signal evaluating circuit 28. The two separate dividers obtained through the first and second voltage dividing blocks 30 and 32 and the third and fourth voltage dividing blocks 36 and 38, respectively, are proposed due to the high voltage during the reverse biased state of the diode MBDi and the extremely low voltage in reverse polarity during the forward biased state of the diode MBD1. Here the first and second voltage dividing blocks 30, 32 have a relationship between each other set to provide, when the first diode MBDi is in the reverse blocking state, a voltage at the first junction as the voltage of the reverse blocking state divided down to a level that can be handled by the first DC/DC converter 34. The third and fourth voltage dividing blocks in turn have a relationship between each other set to provide, when the first diode MBDi is in the forward conduction state, a voltage corresponding to the forward bias voltage of the forward conduction state at a level that can be handled by the first DC/DC converter 34.

The selecting block 35 then selects input voltage to be applied between the input terminals of the first DC/DC converter 34 based on voltage level and polarity as well as reverses the polarity of the selected voltage if appropriate. The selecting block 35 thus selects if the voltage corresponding to voltage of the forward conduction state at the second junction or the divided down voltage of the reverse blocking state at the first junction is to be supplied to the first DC/DC converter 34. It may also reverse the polarity of one of the voltages.

The first and second voltage dividing blocks 30 and 32 are selected when the diode MBDi is reverse biased such that at the first junction between these blocks there is provided a voltage having a level that can be handled by the converter 34. The voltage may for instance be divided down around 1000 times to a considerably lower level.

When the diode MBDi is forward biased, the third and the fourth voltage dividing blocks 36 and 40 will instead be selected and divide the voltage across the diode MBDi down to the level that can be used as input voltage by the converter 34. This division may be marginal, since the diode voltage already is low.

The converter 34 then takes the input voltage selected by the selecting block 33 from either the first junction between the first and the second voltage divider blocks 30 and 32 or the second junction between the third and fourth voltage divider blocks 36 and 38. The first DC/DC converter 34 thus receives the input voltage from voltage dividers at the required level based on the diode operating mode. The DC/DC converter 34 then produces a steady and stable output voltage to feed the signal evaluating circuit 28. The same first DC/DC converter 34 can be used for both the operating modes of diode (ON & OFF).

It is possible to vary the power supply circuit 24 somewhat and omit the third and fourth voltage dividing blocks. This is schematically shown in fig. 9. The number of high voltage dividers may thus be reduced to one. The reduction may be made in case of the power supply loading, forward voltage drop, and the reverse voltage standoff loss can be reduced by optimizing the signal evaluating circuit. As before, when the first diode MBDi is in the reverse blocking state, the first and second voltage dividing blocks 30, 32 have a relationship between each other set to provide a voltage at the first junction as the voltage of the reverse blocking state divided down to a level that can be handled by the first DC/DC converter 34. However, in addition to this, when the first diode MBDi is in the forward conduction state, the first and second voltage dividing blocks have a relationship between each other set to provide the voltage corresponding to the voltage of the forward conduction state at the first junction at a level that can be handled by the first DC/DC converter. In order to achieve this the first and second voltage dividing blocks 30 and 32 may be realized in the same way as the voltage handling blocks of the voltage dividing circuit. The selecting block 35 may in this case reverse the polarity of the applied voltage, when appropriate.

One realization of the selecting block may in this case be as two strings connected between junctions between voltage dividing blocks and the first input of the first DC/DC converter. In the example in fig. 9, it may be realized as a first string with a diode connected between the first junction and the first input of the first DC/DC converter and as a second string with a second inverting DC/DC converter and a diode also connected between the first junction and the first input of the first DC/DC converter. The two strings would thus be parallel. Also in this case the diode of the second string would be placed after the second converter, i.e. the second converter would be connected to the first input of the first DC/DC converter via the diode. Both diodes would furthermore be connected to the first input of the first DC/DC converter with their cathodes. As an alternative it is possible that there is only one connection from the first junction to any one of the inputs of the selecting block. In this case the first DC/DC converter may be an inverting DC/DC converter, if needed.

The voltage dividing blocks of the power supply circuit and/or the voltage handling blocks of the voltage dividing circuit described above may have been realized only using passive components. In this regard it should also be mentioned that it is noted that the first DC/DC converter and the second DC/DC converter, if present, are self-operating DC/DC converters, where the power for operation is obtained from the converter input using a starting circuit. Alternatively it is possible that these converters are also realized only using passive components.

The invention has a number of advantages. It provides a simple but effective and reliable way of monitoring the health of a unidirectional conduction element in a circuit breaker, such as a diode in a diode valve. The diode voltage is fed to the signal evaluating circuit where a decision is made on the diode operating mode and possibly also on the health. All these functionalities can be achieved with a simple circuit and with just one fiber optic cable to the main control system at the ground potential. The health of the diode is thus monitored in a simple and reliable way. It is possible to identify and notify the diode mode of operation along with the information regarding the health of the diode to the main control unit on the ground potential. This is safely done even though the monitored voltage is both at extremely low levels (diode on condition) and at high levels (diode off condition). It may additionally be done without the use of any external power supply. It is also possible to indicate the health of the diode with a simple protocol to the main control unit.

While the invention has been described in connection with what is presently considered to be most practical and preferred embodiments, it is to be understood that the invention is not to be limited to the disclosed embodiments, but on the contrary, is intended to cover various modifications and equivalent arrangements. Therefore, the invention is only to be limited by the following claims.

**Claims**

1. A health investigating arrangement (22) for a first unidirectional conducting and reverse-bias turn off element (MBD1) acting as a main circuit breaker element of a circuit breaker (20) connected in series with a direct current power transmission medium (18), the element having a reverse blocking state (S1) with a first voltage level, a forward conduction state (S2) with a second voltage level and a faulty state (S3) with a third voltage level, wherein the absolute value of the second voltage level is higher than the absolute value of the third voltage level and the absolute value of the first voltage level is more than ten times higher than the absolute value of the second voltage level, the health investigating arrangement (22) comprising a voltage dividing circuit (26) which when monitoring health is connected in parallel with the first unidirectional conducting element (MBD1), the voltage dividing circuit (26) comprising: a first voltage handling block (40) connected in series with a second voltage handling block (42), the first voltage handling block (40) comprising a first voltage dividing component (R1) and the second voltage handling block (42) comprising a second voltage dividing component (R2), the first and second voltage dividing components (R1, R2) having a relationship between each other set to divide the voltage of the reverse blocking state (S1) down to a level that can be handled by a signal evaluating circuit (28), where a junction between the first and second voltage handling blocks (40, 42) forms a health signal output on which a health signal (Vmon) capable of representing said states of the first unidirectional conducting element is provided, wherein the second voltage handling block (42) comprises a second unidirectional conducting element (D2) with opposite orientation compared with the first unidirectional conducting element (MBD1) in order to remove the voltage division of the first and second voltage dividing components from the health signal when the first unidirectional conducting element is in the forward conduction state (S2).

2. The health investigating arrangement (22) according to claim 1, wherein the second voltage diving component (R2) and the second unidirectional conducting element (D2) are connected in series.

3. The health investigating arrangement (22) according to claim 2, wherein the second voltage handling block (42) comprises a further reactive component (C2) connected in parallel with the second voltage dividing element (R2) and the second unidirectional conducting element (D2).

4. The health investigating arrangement (22) according to claim 3, wherein the reactive component (C2) is a capacitor.

5. The health investigating arrangement (22) according to claim 3 or 4, wherein the first voltage handling block (40) comprises, connected in parallel with the first voltage dividing component (R1), a reactive component (C1) of the same type as the reactive component (C2) in the second voltage handling block (42).

6. The health investigating arrangement (22) according to any previous claim 4, further comprising a signal evaluating circuit (28) configured to determine the state of the first unidirectional conducting element (MDB1) based on the health indication signal (Vmon).

7. The health investigating arrangement (22) according to claim 6, wherein the signal evaluating circuit (28) is configured to determine the state of the first unidirectional conducting element (MDB1) through comparing the health indication signal (Vmon) with three different thresholds, each associated with a corresponding state and indicate the state for which the corresponding threshold is crossed.

8. The health investigating arrangement (22) according to claim 6, wherein the signal evaluating circuit (28) is configured to code the voltage level of the health indication signal (Vmon) into a pulse train having a pulse repetition rate corresponding to the voltage level of the health indication signal (Vmon) in order to indicate the state.

9. The health investigating arrangement (22) according to any previous claim, further comprising a power supply circuit (24) for supplying power to circuits of the arrangement, the power supply circuit (24) comprising a direct current/direct current, DC/DC, converter (34) and a first and a second voltage dividing block (30, 32), said first voltage dividing block (30) being connected in a first string in series with the second voltage dividing block (32), said first string being connected in parallel with the first unidirectional conducting element (MBD1), where a first junction between the first and the second voltage dividing blocks (30, 32) is connected to a first input of the DC/DC converter (34) and the first and second voltage dividing blocks (30, 32) have a relationship between each other set to provide, when the first unidirectional conducting element (MBD1) is in the reverse blocking state, a voltage at said first junction as the voltage of the reverse blocking state divided down to a level that can be handled by the DC/DC converter (34), wherein the power supply circuit (24) is also configured to provide, when the first unidirectional conducting element (MBD1) is in the forward conduction state, a voltage corresponding to the voltage of the forward conduction state at a level that can be handled by the DC/DC converter (34).

10. The health investigating arrangement (22) according to claim 9, wherein when the first unidirectional conducting element (MBD1) is in the forward conduction state, the first and second blocks have a relationship between each other set to provide the voltage corresponding to the voltage of the forward conduction state at the first junction at a level that can be handled by the DC/DC converter (34).

11. The health investigating arrangement (22) according to claim 9, further comprising a second string with a third voltage dividing block (36) connected in series with a fourth voltage dividing block (38), said second string being connected in parallel with the first unidirectional current conducting element (MBD1), wherein a second junction between the third and fourth voltage dividing blocks is connected to the first input of the DC/DC converter (34) and the third and fourth voltage dividing blocks have a relationship between each other set to provide, when the first unidirectional conducting element (MBD1) is in the forward conduction state, the voltage corresponding to the voltage of the forward conduction state at a level that can be handled by the DC/DC converter (34) at the second junction.

12. The health investigating arrangement (22) according to any of claims 9 - 11, further comprising a selecting block (35) connected between the first junction and the first input of the DC/DC converter (34), the selecting block being configured to select if the voltage corresponding to the voltage of the forward conduction state or the divided down voltage of the reverse blocking state is to be supplied to the DC/DC converter (34).

13. The health investigating arrangement according to claim 12, wherein the selecting block is further configured to reverse the polarity of one of the voltages.

14. A circuit breaker (20) connected in series with a direct current power transmission medium (18), said circuit breaker comprising a unidirectional conducting element (MBD1) acting as a main circuit breaker element and a health investigating arrangement (22) according any previous claim.

15. A power transmissions system comprising a transmission medium and a series-connected circuit breaker (20) according to claim 14.

**Patentansprüche**

1. Gesundheitsuntersuchungsanordnung (22) für ein erstes unidirektional leitendes und Sperrvorspannungs-Ausschaltelement (MBD1), das als ein Hauptleistungsschaltelement eines Leistungsschalters (20) dient, das in Reihe mit einem Gleichstromleistungsübertragungsmedium (18) geschaltet ist, wobei das Element einen Rückwärtssperrzustand (S1) mit einem ersten Spannungspegel, einen Vorwärtsleitungszustand (S2) mit einem zweiten Spannungspegel und einen Fehlerzustand (S3) mit einem dritten Spannungspegel aufweist, wobei der Betrag des zweiten Spannungspegels über dem Betrag des dritten Spannungspegels liegt und der Betrag des ersten Spannungspegels mehr als zehnmal höher ist als der Betrag des zweiten Spannungspegels, wobei die Gesundheitsuntersuchungsanordnung (22) eine Spannungsteilerschaltung (26) umfasst, die beim Überwachen von Gesundheit parallel zu dem ersten unidirektional leitenden Element (MBD1) geschaltet ist, wobei die Spannungsteilerschaltung (26) umfasst: einen ersten Spannungsverarbeitungsblock (40), geschaltet in Reihe mit einem zweiten Spannungsverarbeitungsblock (42), wobei der erste Spannungsverarbeitungsblock (40) eine erste Spannungsteilerkomponente (R1) umfasst und der zweite Spannungsverarbeitungsblock (42) eine zweite Spannungsteilerkomponente (R2) umfasst, wobei die erste und zweite Spannungsteilerkomponente (R1, R2) eine Beziehung zwischeneinander aufweisen, die gesetzt ist zum Teilen der Spannung des Rückwärtssperrzustands (S1) herunter zu einem Pegel, der durch eine Signalevaluierungsschaltung (28) verarbeitet werden kann, wobei ein Übergang zwischen dem ersten und zweiten Spannungsverarbeitungsblock (40, 42) einen Gesundheitssignalausgang bildet, auf dem ein Gesundheitssignal (Vmon), das die Zustände des ersten unidirektional leitenden Elements darstellen kann, bereitgestellt wird, wobei der zweite Spannungsverarbeitungsblock (42) ein zweites unidirektional leitendes Element (D2) mit entgegengesetzter Orientierung verglichen mit dem ersten unidirektional leitenden Element (MBD1) umfasst, um die Spannungsteilung der ersten und zweiten Spannungsteilerkomponente von dem Gesundheitssignal zu entfernen, wenn sich das erste unidirektional leitende Element in dem Durchlassleitungszustand (S2) befindet.

2. Gesundheitsuntersuchungsanordnung (22) nach Anspruch 1, wobei die zweite Spannungsteilerkomponente (R2) und das zweite unidirektional leitende Element (D2) in Reihe geschaltet sind.

3. Gesundheitsuntersuchungsanordnung (22) nach Anspruch 2, wobei der zweite Spannungsverarbeitungsblock (42) eine weitere Blindkomponente (C2) umfasst, die parallel zu dem zweiten Spannungsteilerelement (R2) und dem zweiten unidirektional leitenden Element (D2) geschaltet ist.

4. Gesundheitsuntersuchungsanordnung (22) nach Anspruch 3, wobei die Blindkomponente (C2) ein Kondensator ist.

5. Gesundheitsuntersuchungsanordnung (22) nach Anspruch 3 oder 4, wobei der erste Spannungsverarbeitungsblock (40) eine Blindkomponente (C1) des gleichen Typs wie die Blindkomponente (C2) in dem zweiten Spannungsverarbeitungsblock (42) umfasst, die parallel zu der ersten Spannungsteilerkomponente (R1) geschaltet ist.

6. Gesundheitsuntersuchungsanordnung (22) nach einem vorhergehenden Anspruch 4, weiter umfassend eine Signalevaluierungsschaltung (28), ausgelegt zum Bestimmen des Zustands des ersten unidirektional leitenden Elements (MDB1) auf Basis des Gesundheitsanzeigesignals (Vmon).

7. Gesundheitsuntersuchungsanordnung (22) nach Anspruch 6, wobei die Signalevaluierungsschaltung (28) ausgelegt ist zum Bestimmen des Zustands des ersten unidirektional leitenden Elements (MDB1) durch Vergleichen des Gesundheitsanzeigesignals (Vmon) mit drei verschiedenen Schwellwerten, wobei jeder mit einem entsprechenden Zustand assoziiert ist und den Zustand anzeigt, für den der entsprechende Schwellwert gekreuzt wird.

**8.** Gesundheitsuntersuchungsanordnung (22) nach Anspruch 6, wobei die Signalevaluierungsschaltung (28) ausgelegt ist zum Codieren des Spannungspegels des Gesundheitsanzeigesignals (Vmon) in eine Impulsfolge mit einer Impulswiederholungsrate entsprechend dem Spannungspegel des Gesundheitsanzeigesignals (Vmon), um den Zustand anzuzeigen.

**9.** Gesundheitsuntersuchungsanordnung (22) nach einem vorhergehenden Anspruch, weiter umfassend eine Stromversorgungsschaltung (24) zum Liefern von Strom an Schaltungen der Anordnung, wobei die Stromversorgungsschaltung (24) einen Gleichstrom-Gleichstrom-, DC/DC-, Wandler (34) und einen ersten und einen zweiten Spannungsteilerblock (30, 32) umfasst, wobei der erste Spannungsteilerblock (30) in einer ersten Kette in Reihe mit dem zweiten Spannungsteilerblock (32) geschaltet ist, wobei die erste Kette parallel zu dem ersten unidirektional leitenden Element (MBD1) geschaltet ist, wobei ein erster Übergang zwischen dem ersten und dem zweiten Spannungsteilerblock (30, 32) mit einem ersten Eingang des DC/DC-Wandlers (34) verbunden ist und der erste und zweite Spannungsteilerblock (30, 32) eine Beziehung zwischeneinander aufweisen, die gesetzt ist zum Bereitstellen, wenn sich das erste unidirektional leitende Element (MBD1) in dem Rückwärtssperrzustand befindet, einer Spannung an dem ersten Übergang als die Spannung des Rückwärtssperrzustands dividiert herunter auf einen Pegel, der durch den DC/DC-Wandler (34) verarbeitet werden kann, wobei die Stromversorgungsschaltung (24) auch ausgelegt ist zum Liefern, wenn sich das erste unidirektional leitende Element (MBD1) in dem Durchlassleitungszustand befindet, einer Spannung entsprechend der Spannung des Durchlassleitungszustands auf einem Pegel, der durch den DC/DC-Wandler (34) verarbeitet werden kann.

**10.** Gesundheitsuntersuchungsanordnung (22) nach Anspruch 9, wobei, wenn sich das erste unidirektional leitende Element (MBD1) in dem Durchlassleitungszustand befindet, der erste und zweite Block eine Beziehung zwischeneinander aufweisen, die gesetzt ist zum Liefern der Spannung entsprechend der Spannung des Durchlassleitungszustands an dem ersten Übergang auf einem Pegel, der durch den DC/DC-Wandler (34) verarbeitet werden kann.

**11.** Gesundheitsuntersuchungsanordnung (22) nach Anspruch 9, weiter umfassend eine zweite Kette mit einem dritten Spannungsteilerblock (36), geschaltet in Reihe mit einem vierten Spannungsteilerblock (38), wobei die zweite Kette parallel zu dem ersten unidirektionalen stromleitenden Element (MBD1) geschaltet ist, wobei ein zweiter Übergang zwischen dem dritten und vierten Spannungsteilerblock mit dem ersten Eingang des DC/DC-Wandlers (34) verbunden ist und der dritte und vierte Spannungsteilerblock eine Beziehung zwischeneinander aufweisen, gesetzt zum Liefern, wenn das erste unidirektional leitende Element (MBD1) sich in dem Durchlassleitungszustand befindet, der Spannung entsprechend der Spannung des Durchlassleitungszustands auf einem Pegel, der durch den DC/DC-Wandler (34) an dem zweiten Übergang verarbeitet werden kann.

**12.** Gesundheitsuntersuchungsanordnung (22) nach einem der Ansprüche 9 - 11, weiter umfassend einen Wahlblock (35), geschaltet zwischen den ersten Übergang und den ersten Eingang des DC/DC-Wandlers (34), wobei der Wahlblock ausgelegt ist zum Wählen, ob die Spannung entsprechend der Spannung des Durchlassleitungszustands oder die heruntergeteilte Spannung des Rückwärtsblockierzustands an den DC/DC-Wandler (34) geliefert werden soll.

**13.** Gesundheitsuntersuchungsanordnung nach Anspruch 12, wobei der Wahlblock weiter ausgelegt ist zum Umkehren der Polarität einer der Spannungen.

**14.** Leistungsschalter (20), geschaltet in Reihe mit einem Gleichstromleistungsübertragungsmedium (18), wobei der Leistungsschalter ein unidirektional leitendes Element (MBD1) umfasst, das als ein Hauptleistungsschalterelement wirkt, und eine Gesundheitsuntersuchungsanordnung (22) nach einem vorhergehenden Anspruch.

**15.** Leistungsübertragungssystem umfassend ein Übertragungsmedium und einen in Reihe geschalteten Leistungsschalter (20) nach Anspruch 14.

**Revendications**

**1.** Agencement d'investigation d'état de santé (22) pour un premier élément à conduction unidirectionnelle et à blocage par polarisation inverse (MBD1) jouant le rôle d'un élément principal de disjoncteur d'un disjoncteur (20) connecté en série avec un support de transmission d'énergie en courant continu (18), l'élément présentant un état bloqué en inverse (S1) avec un premier niveau de tension, un état conducteur dans le sens direct (S2) avec un deuxième niveau de tension et un état défectueux (S3) avec un troisième niveau de tension, la valeur absolue du deuxième niveau de tension étant supérieure à la valeur absolue du troisième niveau de tension et la valeur absolue du premier niveau de tension étant plus de dix fois supérieure à la valeur absolue du deuxième niveau de tension, l'agencement d'investigation d'état de santé (22) comprenant un circuit diviseur de tension (26) qui, lors de la surveillance de l'état de santé, est connecté en parallèle avec le premier élément à conduction unidirectionnelle (MBD1), le circuit diviseur de tension (26) comprenant : un premier bloc de manipulation de tension (40) connecté en série avec un deuxième bloc de manipulation de tension (42), le premier bloc de manipulation de tension (40) comprenant un premier composant diviseur de tension (R1) et le deuxième bloc de manipulation de tension (42) comprenant un deuxième composant diviseur de tension (R2), les premier et deuxième composants diviseurs de tension (R1, R2) étant liés par une relation définie de manière à diviser la tension de l'état bloqué en inverse (S1) jusqu'à un niveau susceptible d'être manipulé par un circuit d'évaluation de signal (28), une jonction entre les premier et deuxième blocs de manipulation de tension (40, 42) formant une sortie de signal d'état de santé sur laquelle est fourni un signal d'état de santé (Vmon) susceptible de représenter lesdits états du premier élément à conduction unidirectionnelle, le deuxième bloc de manipulation de tension (42) comprenant un deuxième élément à conduction unidirectionnelle (D2) d'orientation opposée à celle du premier élément à conduction unidirectionnelle (MBD1) afin de supprimer la division de tension des premier et deuxième composants diviseurs de tension du signal d'état de santé lorsque le premier élément à conduction unidirectionnelle occupe l'état de conduction dans le sens direct (S2).

2. Agencement d'investigation d'état de santé (22) selon la revendication 1, dans lequel le deuxième composant diviseur de tension (R2) et le deuxième élément à conduction unidirectionnelle (D2) sont connectés en série.

3. Agencement d'investigation d'état de santé (22) selon la revendication 2, dans lequel le deuxième bloc de manipulation de tension (42) comprend un composant réactif supplémentaire (C2) connecté en parallèle avec le deuxième élément diviseur de tension (R2) et le deuxième élément à conduction unidirectionnelle (D2).

4. Agencement d'investigation d'état de santé (22) selon la revendication 3, dans lequel le composant réactif (C2) est un condensateur.

5. Agencement d'investigation d'état de santé (22) selon la revendication 3 ou 4, dans lequel le premier bloc de manipulation de tension (40) comprend, connecté en parallèle avec le premier composant diviseur de tension (R1), un composant réactif (C1) du même type que le composant réactif (C2) dans le deuxième bloc de manipulation de tension (42).

6. Agencement d'investigation d'état de santé (22) selon l'une quelconque des revendications précédentes 4, comprenant en outre un circuit d'évaluation de signal (28) configuré pour déterminer l'état du premier élément à conduction unidirectionnelle (MDB1) sur la base du signal d'indication d'état de santé (Vmon).

7. Agencement d'investigation d'état de santé (22) selon la revendication 6, dans lequel le circuit d'évaluation de signal (28) est configuré pour déterminer l'état du premier élément à conduction unidirectionnelle (MDB1) en comparant le signal d'indication d'état de santé (Vmon) à trois seuils différents, associés chacun à un état correspondant, et indiquer l'état pour lequel le seuil correspondant est franchi.

8. Agencement d'investigation d'état de santé (22) selon la revendication 6, dans lequel le circuit d'évaluation de signal (28) est configuré pour coder le niveau de tension du signal d'indication d'état de santé (Vmon) dans un train d'impulsions ayant un taux de répétition d'impulsions correspondant au niveau de tension du signal d'indication d'état de santé (Vmon) dans le but d'indiquer l'état.

9. Agencement d'investigation d'état de santé (22) selon l'une quelconque des revendications précédentes, comprenant en outre un circuit d'alimentation (24) pour alimenter des circuits de l'agencement, le circuit d'alimentation (24) comprenant un convertisseur courant continu/courant continu, CC/CC, (34) et un premier et un deuxième bloc diviseur de tension (30, 32), ledit premier bloc diviseur de tension (30) étant connecté dans une première chaîne en série avec le deuxième bloc diviseur de tension (32), ladite première chaîne étant connectée en parallèle avec le premier élément à conduction unidirectionnelle (MBD1), une première jonction entre le premier et le deuxième bloc diviseur de tension (30, 32) étant connectée à une première entrée du convertisseur CC/CC (34) et les premier et deuxième blocs diviseurs de tension (30, 32) étant liés par une relation définie de manière à fournir, lorsque le premier élément à conduction unidirectionnelle (MBD1) occupe l'état bloqué en inverse, une tension à ladite première jonction sous forme de la tension de l'état bloqué en inverse divisée jusqu'à un niveau susceptible d'être manipulé par le convertisseur CC/CC (34), le circuit d'alimentation (24) étant également configuré pour fournir, lorsque le premier élément à conduction unidirectionnelle (MBD1) occupe l'état de conduction dans le sens direct, une tension correspondant à la tension de l'état de conduction dans le sens direct à un niveau susceptible d'être manipulé par le convertisseur CC/CC (34).

10. Agencement d'investigation d'état de santé (22) selon la revendication 9, dans lequel, lorsque le premier élément à conduction unidirectionnelle (MBD1) occupe l'état de conduction dans le sens direct, les premier et deuxième blocs sont liés par une relation définie de manière à fournir la tension correspondant à la tension de l'état de conduction dans le sens direct à la première jonction à un niveau susceptible d'être manipulé par le convertisseur CC/CC (34).

11. Agencement d'investigation d'état de santé (22) selon la revendication 9, comprenant en outre une deuxième chaîne avec un troisième bloc diviseur de tension (36) connecté en série avec un quatrième bloc diviseur de tension (38), ladite deuxième chaîne étant connectée en parallèle avec le premier élément à conduction de courant unidirectionnelle (MBD1), une deuxième jonction entre les troisième et quatrième blocs diviseurs de tension étant connectée à la première entrée du convertisseur CC/CC (34) et les troisième et quatrième blocs diviseurs de tension étant liés par une relation définie de manière à fournir, lorsque le premier élément à conduction unidirectionnelle (MBD1) occupe l'état de conduction dans le sens direct, la tension correspondant à la tension de l'état de conduction dans le sens direct à un niveau susceptible d'être manipulé par le convertisseur CC/CC (34) à la deuxième jonction.

12. Agencement d'investigation d'état de santé (22) selon l'une quelconque des revendications 9 à 11, comprenant en outre un bloc de sélection (35) connecté entre la première jonction et la première entrée du convertisseur CC/CC (34), le bloc de sélection étant configuré pour sélectionner s'il convient de fournir au convertisseur CC/CC (34) la tension correspondant à la tension de l'état de conduction dans le sens direct ou bien la tension divisée de l'état bloqué en inverse.

13. Agencement d'investigation d'état de santé selon la revendication 12, dans lequel le bloc de sélection est configuré en outre pour inverser la polarité d'une des tensions.

14. Disjoncteur (20) connecté en série avec un support de transmission d'énergie en courant continu (18), ledit disjoncteur comprenant un élément à conduction unidirectionnelle (MBD1) jouant le rôle d'un élément principal de disjoncteur et un agencement d'investigation d'état de santé (22) selon l'une quelconque des revendications précédentes.

15. Système de transmission d'énergie, comprenant un support de transmission et un disjoncteur (20) connecté en série selon la revendication 14.

Fig. 1

Fig. 2

Fig. 3

Fig. 4

Fig. 5

$V_{mon}$

Fig. 6

Fig. 7

S1

S2

S3

Fig. 8

24    26

30

40

MBD1

35

V_mon

32    34

42

Fig. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040125518 A
- CH 513539
- WO 2017157440 A1
- US 3745548 A
- CN 107422257 A